(19) **Europäisches Patentamt / European Patent Office / Office européen des brevets**

(11) **EP 4 239 344 B1**

(12) **EUROPEAN PATENT SPECIFICATION**

(45) Date of publication and mention
of the grant of the patent:
**07.05.2025 Bulletin 2025/19**

(21) Application number: **22159484.9**

(22) Date of filing: **01.03.2022**

(51) International Patent Classification (IPC):
**G01R 31/08** (2020.01)

(52) Cooperative Patent Classification (CPC):
**G01R 31/085; Y04S 10/52**

(54) **PHASE SELECTION METHOD**

VERFAHREN ZUR PHASENAUSWAHL

PROCÉDÉ DE SÉLECTION DE PHASE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.09.2023 Bulletin 2023/36**

(73) Proprietor: **Hitachi Energy Ltd
8050 Zürich (CH)**

(72) Inventors:
• **Wang, Jianping**
724 60 Västerås (SE)
• **Li, YouYi**
722 19 Västerås (SE)
• **Hohn, Fabian**
722 26 Västerås (SE)

(74) Representative: **AWA Sweden AB
Box 45086
104 30 Stockholm (SE)**

(56) References cited:
US-A1- 2017 356 965    US-A1- 2019 170 801
US-A1- 2020 103 455    US-B2- 10 222 409

• LUO SIBEI ET AL: "Fast phase selection method based on transient current for UHV transmission lines", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2018, no. 15, 1 October 2018 (2018-10-01), pages 938 - 943, XP006070069, DOI: 10.1049/JOE.2018.0269

• YAO CHENGUO ET AL: "A novel method to locate a fault of transmission lines by shielding failure", IEEE TRANSACTIONS ON DIELECTRICS AND ELECTRICAL INSULATION, IEEE SERVICE CENTER, PISCATAWAY, NJ, US, vol. 21, no. 4, 1 August 2014 (2014-08-01), pages 1573 - 1583, XP011557362, ISSN: 1070-9878, [retrieved on 20140813], DOI: 10.1109/TDEI.2014.004321

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical field

The present disclosure generally relates to fault detection in power systems. Specifically, it relates to a method for determining a fault in a power line.

### Background

Transmission lines are a vital part of the electrical distribution system, as they provide the path to transfer power between generation and load. Transmission lines are ideally tightly interconnected for reliable operation. Factors like de-regulated market environment, economics, right-of-way clearance and environmental requirements have pushed utilities to operate transmission lines close to their operating limits. Any fault, if not detected and isolated quickly will cascade into a system wide disturbance causing widespread outages for a tightly interconnected system operating close to its limits. Transmission protection systems are designed to identify the location of faults and isolate only the faulted section. The key challenge to the transmission line protection lies in reliably detecting and isolating faults compromising the security of the system.

Phase selection is the determination of which phases are involved in a fault. Phase selection functionality is one of the important protection functions for selective tripping in case of transmission line faults. In many implementations, single phase tripping may be highly advantageous in case of phase to ground faults, which represent more than 60% of transmission line faults. By using phase selection logic, it is possible to trip only faulty phases so that the healthy phases are connected in the remaining system. In this way, the overall power system stability can be maintained.

In wind farm connected power grids, the distance protection located in the wind farm side has met new challenges both in phase selection and line fault identification due to the non-linear behaviors of the system. As a weak system source with non-linear behaviors during fault conditions, it is desired to provide new solutions for reliable phase selection.

Earlier solutions provide phase selection based on change of phase currents or change of phase voltages. In wind farm connected power grids, it has been found that the method based on change of phase currents could not provide full selectivity. On the other hand, it has also been found that the phase selection method based on change of phase voltages might not work well in case of strong system conditions, although it might function for wind farm connected grids. The prior art paper "Fast phase selection method based on transient current for UHV transmission lines", by Luo et al, JOURNAL OF ENGINEERING, INSTITUTION OF ENGINEERING AND TECHNOLOGY, UK, vol. 2018, no. 15, 1 October 2018, pages 938-943, XP006070069, discloses an arrangement for determining if a fault has occurred in a three phase power line, whether the fault is a phase/phase or a phase/ ground loop, and which phases are involved. Currents on the three phases are sampled, incremental values detected and compared with thresholds, wherein the ratios of the incremental values are also formed, and their values compared with thresholds.

It has therefore become a desire to develop a more generalized phase selection solution using single end measurements, which can meet both the weak end system and strong source system conditions.

### Summary

It is therefore an object of the present invention to overcome at least some of the above-mentioned drawbacks, and to provide improved fault determination and phase selection for power lines.

This and other objects are achieved by means of two methods, a device and a computer readable medium comprising instructions as defined in the appended independent claims. Other embodiments are defined by the dependent claims.

According to a first aspect of the present disclosure, a method for determining a type of fault in a power line is provided. The method comprises obtaining voltage and current measurements at a measurement point of the power line. The method further comprises determining transient energies over a first time period for a number of phase-to-ground loops and phase-to-phase loops of the power line based on the obtained voltage and current measurements. The method further comprises determining transient energy ratios for the phase-to-ground loops and the phase-to-phase loops. The method further comprises comparing the transient energy ratios with thresholds corresponding to the phase-to-ground loops or phase-to-phase loops. The method further comprises determining a type of fault based on the comparison.

It is common that power lines have three phases. For such three-phase power lines, there are three phase-to-phase loops and three phase-to-ground loops.

According to some embodiments, the determining the transient energy ratios may comprise dividing a phase-to-ground loop transient energy by a lowest one of the phase-to-ground loop transient energies. The determining the transient energy ratios may further comprise dividing a phase-to-phase loop transient energy by a lowest one of the phase-to-phase loop transient energies.

The method may comprise dividing each phase-to-phase loop transient energy by the lowest one of the phase-to-phase loop transient energies.

The method may comprise dividing each phase-to-ground loop transient energy by the lowest one of the phase-to-ground loop transient energy.

Thereby, the transient energies of the loops of a type (meaning phase-to-phase type and/or phase-to-ground type) may be normalized relative to the other loops of the same type. Normalizing the transient energies of the loops of a type may facilitate comparison of the relative sizes of the transient energies of the loop type. Specifically, if the transient energy ratios are based on normalizing the transient energies, at least one transient energy of each loop type, i.e., the lowest one, will be equal to one.

According to some embodiments, determining the transient energy ratios may comprise, if the absolute value of the lowest one of the phase-to-ground loop transient energies is below a first predetermined minimal value, each phase-to-ground loop transient energy ratio may be replaced by a first replacement value. Further, if the absolute value of the lowest one of the phase-to-phase loop transient energies is below a second predetermined minimal value, each phase-to-phase loop transient energy ratio may be replaced by a second replacement value.

If the lowest transient energy of a loop type (i.e., the lowest phase-to-phase loop transient energy or the lowest phase-to-ground loop transient energy) is too close to zero, the algorithm may become unstable. Therefore, if the divisor is too close to zero (i.e., absolute value below a predetermined minimal value/threshold), the related ratios may be replaced by a large number, such as 1000.

According to some embodiments, the method may further comprise obtaining further voltage and current measurements at the measurement point during a second time period. The method may further comprise determining further transient energies over the second time period for the number of phase-to-ground loops and the number of phase-to-phase loops. The method may further comprise determining further transient energy ratios for the phase-to-ground loops and the phase-to-phase loops. The method may further comprise comparing the further transient energy ratios with the thresholds corresponding to the phase-to-ground loops or phase-to-phase loops. The determining a type of fault may be based on the comparison of the transient energy ratios and the comparison of the further transient energy ratios.

In this case, the determination of the fault is based on measurements taken during at least two time periods. Therefore, the determination of the fault may be confirmed at least once before a final determination is made. Such embodiments may provide a more reliable method for determining a fault.

According to some embodiments, the types of faults to be determined may include phase-to-ground faults and phase-to-phase faults.

Different types of faults may occur in a power line. For example, a single-phase to ground fault may occur if one conductor drops to the ground or comes in contact with the neutral conductor of the power line. In such a fault, there is an insulation breakdown between one of the phases and earth. Similarly, in a two-phase-to ground fault, two phases are connected to ground. In a phase-to-phase fault, two phases are connected together, while in a three-phase fault, all three phases are connected together.

The method may be (or include) a phase selection method. The method may determine which phases of a power line are involved in a fault.

According to some embodiments, the method may further comprise obtaining at least one fault candidate loop among the number of phase-to-ground loops and phase-to-phase loops. The determining a type of fault may further be based on the at least one obtained fault candidate loop.

The at least one fault candidate loop may be a list of loops in which it has previously been determined that a fault may have occurred. Such a determination may for example be based on measurements made at the power line. The method for determining a type of fault in a power line may be triggered by the existence of at least one fault candidate loop.

There are different methods for determining fault candidate loops. For example, the determination of fault candidate loops may be performed as part of a start-up functionality. Some methods for determining fault candidate loops may comprise determining a fault indication quantity for each of the number of phase-to-ground loops and phase-to-phase loops of the power line based on the obtained voltage and current measurements. Obtaining the at least one fault candidate loop may further comprise comparing each fault indication quantity with a dedicated interval and, if any one of the fault indication quantities is outside its dedicated interval, identifying each phase-to-ground loop and/or phase-to-phase loop which related fault indication quantity exceeds its dedicated interval as a fault candidate loop.

A fault indication quantity may be a value obtained or calculated from the obtained voltage and current measurements. A fault indication quantity may for example be one of a current, incremental current, voltage or incremental voltage. The fault indication quantity may be compared with a dedicated interval, to see whether the fault indication quantity is within normal operating conditions. A fault indication quantity being outside of its dedicated interval may be an indication that a fault may have occurred in the loop related to the fault indication quantity.

According to some embodiments, a three-phase fault may be determined if: a zero-mode voltage, obtained from the obtained voltage and current measurements, is below a first zero-mode voltage threshold, a zero-mode current, obtained from the voltage and current measurements, is below a first zero-mode current threshold, all the determined phase-to-ground loop transient energy ratios are below a first threshold level, and the at least one fault candidate loop comprises all three phase-to-ground loops and all three phase-to-phase loops.

In a three-phase fault, a connection is made between the three phases. In theory, such a fault may not lead to any zero-mode current or voltage. In practice, for a three-phase fault the zero-mode current may therefore be below a first zero-mode current threshold. Further, in practice and for a three-phase fault, the zero-mode voltage may be below a first zero-mode voltage threshold.

Further, in theory and for a three-phase fault, the absolute values of the transient energies of each of the phase-to-ground loops may be substantially equal. Therefore, the difference between the transient energy ratios of the phase-to-ground loops may be small, or below a first threshold level.

Furthermore, in a three-phase fault for a three-phase power line, all the loops (phase-to-ground and phase-to-phase) may involve a faulty phase. Therefore, a determination of fault candidate loops may have flagged/identified all the loops as fault candidate loops.

According to some embodiments, a single-phase-to-ground fault may be determined for a given phase, if: the phase-to-ground loop transient energy ratio for the given phase is higher than the other phase-to-ground loop transient energy ratios, the phase-to-phase loop transient energy ratios involving the given phase are higher than the phase-to-phase loop transient energy ratios not involving the given phase, and the phase-to-ground loop for the given phase is a fault candidate loop.

In a single phase to ground fault, a connection is made between one phase and ground. In such a fault, the transient energy of the phase-to-ground loop involving the faulty phase may be larger than the transient energies of the other phase-to-ground loops. The transient energy ratio of the phase-to-ground loop involving the faulty phase may be higher than a threshold, and the transient energy ratios of the other phase-to-ground loops may be lower than the same threshold (e.g., a first single-phase-to-ground threshold).

Further, the transient energies for the phase-to-phase loops involving the faulty phase may be higher than the transient energy for the phase-to-phase loop not involving the faulty phase. The transient energy ratio of the phase-to-phase loops involving the faulty phase may be higher than a threshold, and the transient energy ratio of the other phase-to-phase loop may be lower than the same threshold (e.g., a second single-phase-to-ground threshold).

Further, a determination of fault candidate loops may have flagged/identified all the loops involving the faulty phase as fault candidate loops.

According to some embodiments, a two-phase-to-ground fault for two given phases is determined if: an incremental zero mode voltage, obtained from the obtained voltage and current measurements, is above a first incremental zero mode voltage threshold level, the phase-to-ground loop transient energy ratios for the two given phases are higher than the other phase-to-ground loop transient energy ratio, and all the phase-to-phase loop transient energy ratios are lower than a second threshold level, and the phase-to-ground loops involving the given phases and the phase-to-phase loop involving the given phases are fault candidate loops.

In a two-phase-to-ground fault, a connection is made between two phases and ground. For grounded faults, zero-mode values (current or voltage) may be large. Therefore, a two-phase-to-ground fault may be determined if an incremental zero mode voltage is above a first incremental zero-mode voltage threshold.

Further, the absolute values of the phase-to-ground-loop transient energies of the involved phases may be higher than the absolute value of the other phase-to-ground loop transient energy. Therefore, for a two-phase-to-ground fault, the phase-to-ground loop transient energy ratios for the two given phases may be higher than a threshold, and the other phase-to-ground loop transient energy ratio may be lower than the same threshold (e.g., a two-phase-to-ground threshold).

Further, for a two-phase-to-ground fault, the difference between the phase-to-phase loop transient energies may be rather small, such that all the phase-to-phase loop transient energy ratios are below a second threshold.

Further, a determination of fault candidate loops may have flagged/identified all the loops involving the faulty phases as fault candidate loops.

According to some embodiments, a two-phase fault may be determined for two given phases if: the phase-to-ground loop transient energy ratios involving the given phases are higher than the other phase-to-ground loop transient energy ratio, all the phase-to-phase-loop transient energy ratios are lower than a third threshold, and the phase-to-ground loops involving the given phases and the phase-to-phase loop involving the given phases are fault candidate loops.

In a two-phase fault, a connection is made between two phases of the power line. For a two-phase fault, the transient energy of the phase-to-ground loops involving the faulty phases may be higher than the transient energy of the other phase-to-ground loop. The transient energy ratio of the phase-to-ground loops involving the faulty phases may be higher than a threshold, and the transient energy ratio of the other phase-to-ground loop may be lower than the same threshold (e.g., a two-phase fault threshold).

Further, for a two-phase fault, the difference between the phase-to-phase loop transient energies may be rather small, such that all the phase-to-phase loop transient energy ratios are below a third threshold.

Further, an earlier determination of fault candidate loops may have flagged/identified all the loops involving the faulty phases as fault candidate loops.

According to a second aspect of the present disclosure, a (second) method for determining a type of fault in a power line is provided. The (second) method comprises obtaining current measurements at a first measurement point of the power line and a second measurement point of the power line. The (second) method further comprises determining incremental differential currents over a first time period for a number of phase-to-ground loops and/or phase-to-phase loops of the power line, based on the obtained current measurements. The (second) method further comprises determining incremental differential current ratios for the phase-to-ground loops and/or phase-to-phase loops. The (second) method further comprises comparing the incremental differential current with thresholds corresponding to the phase-to-ground loops or phase-to-phase loops and determining (4060) a type of fault based on the comparison. According to the (second) method, the type of fault is determined to be a single-phase-to-ground fault for a given phase if the phase-to-ground loop incremental differential current ratio for the given phase is larger than the other phase-to-ground loop ratios and if the phase-to-phase loop incremental differential current ratios involving the given phase are larger than the other phase-to-phase loop incremental differential current ratio.

According to a third aspect of the present disclosure, a device for determining a type of fault in a power line is provided. The device is configured to obtain voltage and current measurements from a measurement point of the power line. The device is further configured to determine transient energies over a first time period for the number of phase-to-ground loops and phase-to-phase loops, based on the obtained voltage and current measurements. The device is further configured to determine transient energy ratios for the phase-to-ground loops and phase-to-phase loops. The device is further configured to compare the transient energy ratios with thresholds corresponding to the phase-to-ground loops or phase-to-phase loops and determine a type of fault based on the comparison.

The device may be configured to cooperate with other devices/units/elements in a fault detection/isolation system. For example, the device may be (or comprise) a phase selection unit for determining a type of fault in a power line.

According to some embodiments, the device may further comprise, or communicate/cooperate with, a start-up element or fault candidate loop determination element. The start-up element may be configured to determine, based on voltage and current measurements from a measurement point of the power line, at least one fault candidate loop among the number of phase-to-ground loops and phase-to-phase loops. The device may further be configured to determine the type of fault based on the at least one fault candidate loop.

Further embodiments of the device may be configured to perform methods in accordance with embodiments of the first and/or second aspect of the disclosure.

According to a fourth aspect of the present disclosure, a computer readable medium comprising instructions is provided. The instructions will, when executed by a processor, bring the processor to obtain voltage and current measurements at a measurement point of the power line. The instructions will further, when executed by a processor, bring the processor to obtain at least one fault candidate loop of a number of phase-to-ground loops and phase-to-phase loops of the power line. The instructions will further, when executed by a processor, bring the processor to determine transient energies over a first time period for the number of phase-to-ground loops and phase-to-phase loops, based on the obtained voltage and current measurements. The instructions will further, when executed by a processor, bring the processor to determine transient energy ratios for the phase-to-ground loops and phase-to-phase loops. The instructions will further, when executed by a processor, bring the processor to compare the transient energy ratios with thresholds corresponding to the phase-to-ground loops or phase-to-phase loops, and determine a type of fault based on the comparison and, optionally, on the at least one fault candidate loop.

The processor executing the instructions may, for example, be part of a device in accordance with the third aspect of the disclosure.

Other embodiments of the third aspect may comprise instruction that, when being executed by a processor, may bring the processor to perform the methods described above with reference to embodiments of the first aspect of the disclosure.

It is noted that other embodiments using all possible combinations of features recited in the above-described embodiments may be envisaged. Thus, the present disclosure also relates to all possible combinations of features mentioned herein.

## Brief description of drawings

Exemplifying embodiments will now be described in more detail, with reference to the following appended drawings:

Figure 1 is a schematic illustration of a power line connected to a protection relay via a current transformer and a voltage transformer;

Figure 2 is a schematic illustration of a power line connected to a protection relay via a current transformer and a voltage transformer;

Figure 3 is a schematic illustration of a system for determining a type of fault in a power line, in accordance with some embodiments;

Figure 4 is a flowchart illustrating a method for determining a type of fault in a power line, in accordance with some embodiments;

Figure 5 is a flowchart illustrating a part of a method for determining a type of fault in a power line, in accordance with some embodiments; and

Figure 6 is a flowchart illustrating a method for determining a type of fault in a power line, in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

## Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

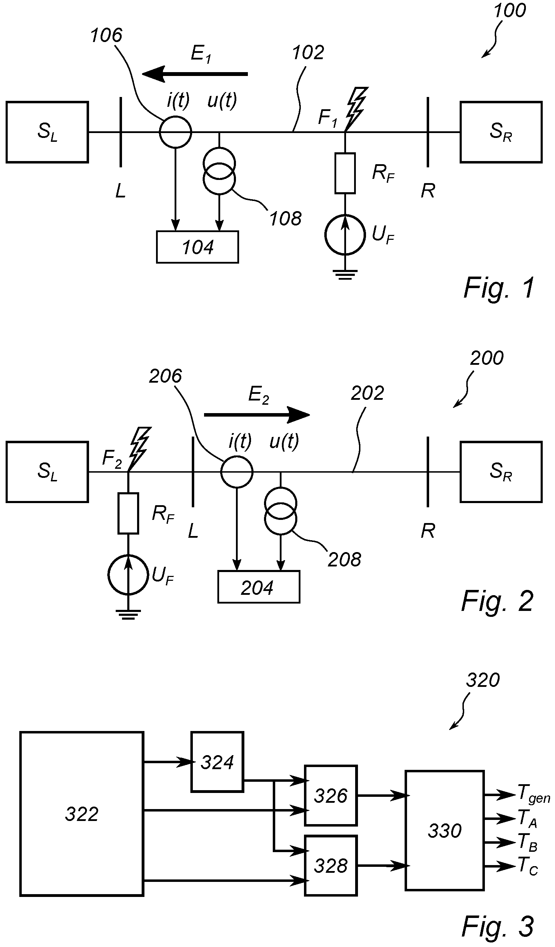

In the Figures, the features are identified by reference numbers made up of the number of the figure to which it relates followed by the number of the feature, which are equivalents for all exemplifying embodiments, e.g., the common feature "10" is indicated by "110" in Fig. 1 while the corresponding feature is indicated by "210" in Fig. 2.

In order to facilitate understanding of the methods and devices provided by the present disclosure, the methods and devices are presented in the context of a fault determination/handling system for a power line.

Figure 1 is an illustration of a fault detection system 100 of a power line. Figure 1 shows a power line 102 connected between two sources, a first local source $S_L$ at a local point L and a second remote source $S_R$ at a remote point R. The sources may for example be voltage sources or current sources. The power line 102 may for example be a three-phase power line. The phases may for example be denoted A, B and C. At the local point L there is also a device for determining a power line fault. The device is in this example implemented as a protection relay 104 connected to the power line 102 via a current transformer 106 and a voltage transformer 108 at a measurement point at one end of the power line, which measurement point is the above-mentioned local point L. The protection relay 104 measures the current i(t) and voltage v(t) of the power line 102 at discrete points in time or time instances, often denoted sampling times. In the figure there is also a first fault $F_1$ on the power line between the local point L and the remote point R. The fault $F_1$ is modelled as a resistance $R_F$ and a voltage source $U_F$ connected to ground. When a fault occurs in the power line, the current and or voltage of the power line is affected, which can be detected in the measurements made by the protection relay 104. In Figure 1, the first fault $F_1$ is located between the relay 104 and the remote point R. The first fault $F_1$ will therefore cause negative transient energy $E_1$ measured at measurement point L. If the protection relay 104 detects negative transient energy $E_1$, a forward fault $F_1$ may be determined.

Figure 2 is an illustration of the same fault detection system 200. All features in Figure 2 are equivalent to the features of Figure 1, except in that, in Figure 2, a second fault $F_2$ is shown on the power line 202 between the local source $S_L$ and the local point L. The second fault $F_2$ will cause positive transient energy $E_2$ to be detected by the protection relay 204. If the protection relay 204 detects negative transient energy $E_2$, a backward fault $F_2$ may be determined.

Figure 3 is a block diagram illustrating a system 320 for determining a type of fault in a power line, in accordance with some embodiments. The system 320 may for example be implemented in a processor/controller. The methods of the present disclosure may be implemented in the system 320. Specifically, at least parts of the method may be implemented in the phase calculation/selection module 326. The device for determining a type of fault in a power line, in accordance with some embodiments, may comprise at least the phase calculation/selection module 326.

The system 320 comprises a measurement obtaining module 322. The measurement obtaining module 322 is configured to obtain voltage and current measurements from a measurement point of a power line, such as the local point L of power line 102, 202 described above with reference to Figures 1 and 2. The voltage and current measurements comprise phase-to-ground loop currents and voltages, and phase-to-phase loop currents and voltages. For a three-phase power line, the phase-to-ground loops may be denoted A-G, B-G, and C-G, and the phase-to-phase-loops may be denoted A-B, B-C, and C-A. The phase-to-ground loop currents and voltages may be denoted $i_A(t)$, $i_B(t)$, $i_C(t)$, $u_A(t)$, $u_B(t)$, and $u_C(t)$.

The phase-to-phase loop currents and voltages may be denoted $i_{AB}(t)$, $i_{BC}(t)$, $i_{CA}(t)$, $u_{AB}(t)$, $u_{BC}(t)$, and $u_{CA}(t)$.

The measurement obtaining module 322 is further configured to provide/output the obtained measurements to a start-up module 324, a phase selection module 326, and a reach calculation module 328.

The method of the present disclosure may be mainly implemented in the phase selection module 326. Certain embodiments of the method may be partially implemented in the start-up module 324.

The fault determination method may include or be a phase selection method. The phase selection method may be preceded by a start-up function, where a certain outcome of processing in the start-up function may trigger the carrying out of the phase selection method. For example, if the start-up function operates to indicate that there is a fault or disturbance on the power line, the phase selection scheme may be started for determining the fault types.

The start-up module 324 is configured to obtain/receive, from the measurement obtaining module 322, current and voltage measurements from a measurement point of the power line 102, 202. The start-up module 324 is further configured to determine which phases may be involved in a fault, if any. The start-up module 324 is further configured to provide/output the resulting at least one fault candidate loop to the phase selection module 326 and the reach calculation module 328.

The phase calculation module 326 obtains voltage and current measurements from a measurement point of the power line 102, 202 via the measurement obtaining module 322 and may obtain at least one fault candidate loop from the start-up module 324. The phase calculation module 326 determines transient energy, and transient energy ratios for each of the phase-to-ground loops and the phase-to-phase loops based on the obtained voltage and current measurements. The phase calculation module 326 is further configured to determine a type of fault based on the transient energy ratios. Optionally, the determination may further be based on the obtained fault candidate loop(s).

The phase calculation module 326 is further configured to provide/output the determined type of fault to the trip decision module 330.

The system 300 further, optionally, comprises a reach calculation module 328. The reach calculation module 328 is configured to receive/obtain voltage and current measurements from a measurement point of the power line 102, 202 via the measurement obtaining module 322, and to obtain at least one fault candidate loop from the start-up module 324. Based on the obtained measurements and fault candidate loop(s), the reach calculation module 328 may determine if the fault is to be handled by the present fault handling system 300. Along a power line 102, 202, there may be more than one fault handling systems 300. In such cases, each fault handling system 300 may be responsible for faults occurring along a specific section of the power line. The reach calculation module 328 may for example determine a location of the fault, or a distance between the measurement point L and the fault based on reach calculations.

The reach calculation module 328 may output/provide its results to the trip decision module 330.

The trip decision module 330 is configured to receive a determined type of fault from the phase calculation module 326. The trip decision module 330 may further receive/obtain an input relating to the position/location of the fault from the reach calculation module 328. The trip decision module 330 may, based on the information received from the calculation module 326 and/or the reach calculation module 328, decide to trip one of more phases of the power line based on the fault determination. The trip decision module 330 may output a general trip decision $T_{gen}$, or trip decisions for one or more individual phases $T_A$, $T_B$, and $T_C$.

The functionality of the fault determination/handling system 300, including one or more of the measurement obtaining module 322, start-up module 324, phase selection module 326, reach calculation module 328 and tripping module 330 may be implemented in at least one integrated circuit such as an Application-Specific Integrated Circuit (ASIC) or Field-Programmable Gate Arrays (FPGA). As an alternative, the modules may be realized as one or more processors acting on computer program instructions in one or more computer memories implementing the module functionality.

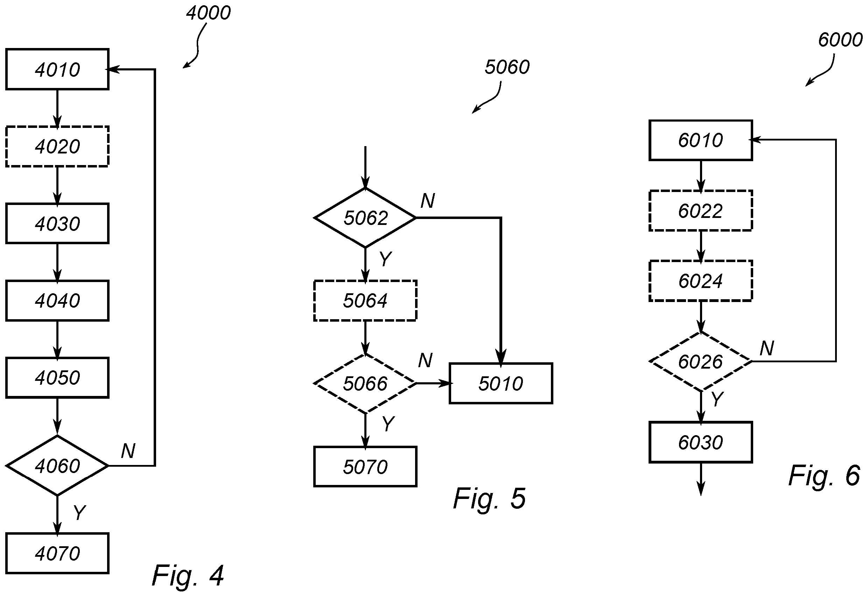

Figure 4 is a flowchart illustrating an embodiment of the method for determining a type of fault in accordance with the first aspect of the present disclosure. The method may for example be implemented in a device or a system, such as the system 300 described above with reference to Figure 3.

The method 4000 comprises, in step 4010, obtaining voltage and current measurements at a measurement point of a power line, such as the power line 102, 202 described above with reference to the preceding figures.

The voltage and current measurements comprise phase-to-ground loop currents denoted $i_A(t)$, $i_B(t)$, $i_C(t)$ and voltages $u_A(t)$, $u_B(t)$, $u_C(t)$, and phase-to-phase loop currents $i_{AB}(t)$, $i_{BC}(t)$, $i_{CA}(t)$ and voltages $u_{AB}(t)$, $u_{BC}(t)$, $u_{CA}(t)$.

At step 4020, the method 4000 may optionally comprise receiving/obtaining at least one fault candidate loop among the phase-to-ground loops A-G, B-G, C-G, and the phase-to-phase loops A-B, B-C, C-A.

At step 4030, the method 4000 further comprises determining (4030) transient energies over a first time period for a number of phase-to-ground loops and phase-to-phase loops of the power line, based on the obtained voltage and current measurements.

The transient energy may be calculated as follows:

$$\Delta E(t) = \int_0^t \Delta u(\tau) \cdot \Delta i(\tau) \cdot d\tau \qquad (1)$$

Here, $\Delta u$ is an incremental voltage of a loop, and $\Delta i$ is an incremental current of the same loop.

The incremental current $\Delta i(t)$ of a loop is the difference between the loop current at a present point in time (or time instance) t and an earlier point in time (or time instance) (t - T). The earlier point in time may be a corresponding point in time in a previous fundamental frequency (50Hz/60Hz) period (T) of the loop current:

$$\Delta i(t) = i(t) - i(t - T)$$

The incremental voltage $\Delta u(t)$ of a loop is the difference between the loop voltage at a present point in time (or time instance) t and an earlier point in time (or time instance) (t - T). The earlier point in time may be a corresponding point in time in a previous fundamental frequency (50Hz/60Hz) period (T) of the measured loop voltage:

$$\Delta u(t) = u(t) - u(t - T)$$

For a three-phase power line having phases A, B and C, the transient energy may be calculated for three phase-to-ground loops, (A-G, B-G, and C-G), and three phase-to-phase loops (A-B, B-C, and C-A), such that in total 6 transient energy indices, $\Delta E_A$, $\Delta E_B$, $\Delta E_C$, $\Delta E_{AB}$, $\Delta E_{BC}$, $\Delta E_{CA}$, may be calculated.

At step 4040, the method 4000 comprises determining transient energy ratios for the phase-to-ground loops and phase-to-phase loops of the power line.

At this step, a phase-to-ground loop transient energy ratio $R_A$, $R_B$, $R_C$ may be determined for each phase, as well as a phase-to-phase loop transient energy ratio $R_{AB}$, $R_{BC}$, $R_{CA}$ between each phase.

A transient energy ratio may optionally be determined as a phase-to-ground loop transient energy or phase-to-phase loop transient energy divided by the lowest of the phase-to-ground loop transient energies or phase-to-phase loop transient energies, respectively.

The transient energy ratios may therefore be normalized, which may make the calculation both more stable and the settings easier. At the same time, it is also helpful to improve the sensitivity and operation speed. For a three-phase powerline, the phase-to-ground loop transient energy ratios may be determined as:

$$R_A = \frac{\Delta E_A}{\min(\Delta E_A, \Delta E_B, \Delta E_C)}$$

$$R_B = \frac{\Delta E_B}{\min(\Delta E_A, \Delta E_B, \Delta E_C)} \qquad (2)$$

$$R_C = \frac{\Delta E_C}{\min(\Delta E_A, \Delta E_B, \Delta E_C)}$$

and the phase-to-phase loop transient energy ratios may be determined as:

$$R_{AB} = \frac{\Delta E_{AB}}{\min(\Delta E_{AB}, \Delta E_{BC}, \Delta E_{CA})}$$

$$R_{BC} = \frac{\Delta E_{BC}}{\min(\Delta E_{AB}, \Delta E_{BC}, \Delta E_{CA})} \qquad (3)$$

$$R_{CA} = \frac{\Delta E_{CA}}{\min(\Delta E_{AB}, \Delta E_{BC}, \Delta E_{CA})}$$

wherein, all the transient energies $\Delta E_X$ are determined using equation (1). It is noted that, when using equations 2 and 3 to determine the transient energy ratios, at least one phase-to-ground loop transient energy ratio, and as least on phase-to-phase loop transient energy ratio is always equal to one.

In some practical applications, the transient energy in the ratio calculations may be very small. If a transient energy is very small, the divisor $\min(\Delta E_A, \Delta E_B, \Delta E_C)$ or $\min(\Delta E_{AB}, \Delta E_{BC}, \Delta E_{CA})$ in the equations 2 and 3 may also become small. In order to make the calculation of ratios (division algorithm) stable, for such cases, the divisor may first be compared with a threshold representing a minimal acceptable divisor value. If a divisor is smaller than the threshold (e.g., zero or near zero), the ratios to be determined using that divisor may be replaced by a pre-set (large) value, such as 1000, to avoid the problem of division by zero.

At step 4050, the method 4000 comprises comparing the determined transient energy ratios $R_A$, $R_B$, $R_C$, $R_{AB}$, $R_{BC}$, $R_{CA}$ with thresholds corresponding to the phase-to-ground loops or phase-to-phase loops. Each transient energy ratio may be compared with its own dedicated threshold or thresholds. Alternatively, there may be a first set of thresholds for the phase-to-ground loop transient energy ratios and a second set of thresholds for the phase-to-phase loop transient energy ratios.

At step 4060, the method comprises, determining a type of fault based on the comparison, and optionally based on the (list of) at least one fault candidate loop. The determination of different types of faults will be further discussed below, with reference to Figure 5.

If, based on the comparison, a fault type can be determined, the method may proceed to signalling the fault at step 4070. If no fault can be determined, the method may return to obtaining (new) measurements at step 4010. New measurements may for example be made during a second, different, time period.

Figure 5 is a flowchart illustrating an embodiment of at least part of the method for determining a type of fault in accordance with the first aspect of the present disclosure. Specifically, the method 5060 shows an embodiment of step 4060, determining a type of fault based on the comparison, of method 4000.

In step 5062, the method 5060 comprises identifying a type of fault based on the comparison and (optionally) based on the at least one fault candidate loop.

For example, a three-phase fault may be identified if the following criteria are met:

1. A zero-mode voltage $V_0$, obtained from the voltage and current measurements, is below a first zero-mode voltage threshold:

$$V_0 < V_0, set$$

2. A zero-mode current $I_0$, obtained from the voltage and current measurements, is below a first zero-mode voltage threshold:

$$I_0 < I_0, set$$

3. All three phase-to-ground loop transient energy ratios $R_A$, $R_B$, $R_C$ are small enough, or below a first threshold S1:

$$R_A, R_B, R_C < S_1$$

4. All loops A-G, B-G, C-G, A-B, B-C, C-A, are fault candidate loops.

A single-phase-to-ground fault for a given phase (using A as an example) may be identified if the following criteria are met:

1. The phase-to-ground loop transient energy ratio involving the given phase $R_A$ is larger than the other phase-to-ground loop ratios $R_B$, $R_C$:

$$R_A > R_B, R_C$$

OR

$$R_A > S_{AG1}$$

$$R_B < S_{AG1}$$

$$R_C < S_{AG1}$$

where $S_{AG1}$ is a first single-phase-to ground threshold.

2. The phase-to-phase loop transient energy ratios involving the given phase $R_{AB}$, $R_{CA}$ are larger than the other phase-to-phase loop transient energy ratio $R_{BC}$:

$$R_{AB}, R_{CA} > R_{BC}$$

OR

$$R_{AB} > S_{AG2}$$

$$R_{CA} > S_{AG2}$$

$$R_{BC} < S_{AG2}$$

where $S_{AG2}$ is a second single-phase-to ground threshold.

3. The loops involving the given phase (A-G, A-B, C-A) are fault candidate loops.

A two-phase to ground fault for two given phases (using B-C as an example) may be identified if the following criteria are met:

1. An incremental zero-mode voltage $\Delta V_0$, obtained from the voltage and current measurements, is large enough, i.e. above a first incremental zero-mode voltage threshold:

$$\Delta V_0 > \Delta V_{0,set}$$

Wherein the incremental zero-mode voltage is the difference between the zero-mode voltage at a present point in time or time instance t and an earlier point in time or time instance (t - T), where the earlier point in time is a corresponding point in time in a previous fundamental frequency period (T) of the zero-mode voltage:

$$\Delta V_0 = V_0(t) - V_0(t - T)$$

2. The phase-to-ground loop transient energy ratios involving the given phases $R_B$, $R_C$ are larger than the other phase-to-ground loop ratio $R_A$:

$$R_B, R_C > R_A$$

OR

$$R_A < S_{BCG1}$$

$$R_B > S_{BCG1}$$

$$R_C > S_{BCG1}$$

where $S_{BCG1}$ is a first two-phase-to ground threshold.

3. All three phase-to-phase loop transient energy ratios $R_{AB}$, $R_{BC}$, $R_{CA}$ are small enough, or below a second threshold $S_2$:

$$R_{AB}, R_{BC}, R_{CA} < S_2$$

4. The phase-to-ground loops involving the given phases (B-G, C-G) and the phase-to-phase loop involving the given phase (B-C) are fault candidate loops.

A two-phase fault for two given phases (using B-C as an example) may be identified if the following criteria are met:

1. The phase-to-ground loop transient energy ratios involving the given phases $R_B$, $R_C$ are larger than the other phase-to-ground loop ratio $R_A$:

$$R_B, R_C > R_A$$

OR

$$R_A < S_{BC1}$$

$$R_B > S_{BC1}$$

$$R_C > S_{BC1}$$

where $S_{BC1}$ is a first two-phase-fault threshold.
2. All three phase-to-phase loop transient energy ratios $R_{AB}$, $R_{BC}$, $R_{CA}$ are small enough, or below a third threshold $S_3$:

$$R_{AB}, R_{BC}, R_{CA} < S_3$$

3. The phase-to-ground loops involving the given phases (B-G, C-G) and the phase-to-phase loop involving the given phase (B-C) are fault candidate loops.

If no fault has been determined in step 5062, the method may return to obtaining (new) measurements at step 5010.

After a fault has been determined in step 5062, the method 5060 may optionally increase a counter related to the type of fault at step 5064.

At step 5066, the method may optionally verify whether the counter relating to a type of fault has reached a value above a predetermined number, i.e., if the type of fault has been identified a predetermined number of times. If the type of fault has not been identified the predetermined number of times, the method may return to obtaining (new) measurements at step 5010. If the type of fault has been identified the predetermined number of times, the type of fault may be determined, and the method may proceed to signalling the fault at step 5070.

The steps 4070, 5070 may comprise submitting information relating to a determined fault to a tripping module which may go ahead and trip one or more of the power line phases based (at least in part) on the information.

Figure 6 is a flowchart illustrating an embodiment of the method for determining a type of fault in accordance with the first aspect of the present disclosure.

In Figure 6, the method 6000 starts by obtaining 6010 measurements as described above with reference to Figure 4.

However, in the method 6000, the phase selection may be preceded by a start-up function at steps 6022-6026, for determining whether there are any fault candidate loops.

At step 6022, the method may comprise determining a fault indication quantity for each of the number of phase-to-ground loops and phase-to-phase loops of the power line based on the obtained voltage and current measurements.

For example, the fault indication quantity may be an incremental current $\Delta i(t)$. The incremental current $\Delta i(t)$ for each loop may be the difference between the loop current at a present point in time or time instance $t$ and an earlier point in time or time instance $(t - T)$, where the earlier point in time is a corresponding point in time in a previous fundamental frequency period $(T)$ of the loop current:

$$\Delta i(t) = i(t) - i(t - T).$$

At step 6024, the method may comprise comparing each fault indication quantity with a dedicated interval and, if any one of the fault indication quantities is outside its dedicated interval, identifying each phase-to-ground loop and/or phase-to-phase loop which related fault indication quantity exceeds its dedicated interval as a fault candidate loop.

When the fault indication quantity is incremental current $\Delta i(t)$, the comparison with a threshold may be as follows:

$$\Delta i(t) > K_1 \times I_N + K_2 \times I_{RMS}$$

Where, $\Delta i(t)$ is the incremental loop current. $I_N$ is the rated current of the current transformer 106. $I_{RMS}$ is the RMS value for the given loop current. $K_1$ and $K_2$ are the settings for the fixed threshold and the floating threshold.

A start-up element/method based on incremental currents may for example work well for power lines in windfarm applications, despite windfarm control possibly bringing non-linear phenomena to the fault currents.

At step 6026, the method may comprise determining whether there are any fault candidate loops. If there are not any fault candidate loops, the method may return to obtaining measurements at step 6010. If there are fault candidate loops, the method may proceed to determining transient energies 6030, determining transient energy ratios 6040 (not depicted) and comparing the transient energy ratios with corresponding thresholds 6050 (not depicted) as described above with reference to steps 4030, 4040 and 4050 of method 4000 in Figure 4.

In some embodiments of the methods described in this disclosure, only potential faults involving fault candidate loops are investigated further. For example, if the (list of) at least one fault candidate loop does not comprise any loop involving phase A, the method may comprise deciding not to investigate A-G (phase A to ground) faults.

Further, the method may comprise determining whether any zero-mode quantities obtained from the measured currents and voltages have crossed a corresponding zero-mode threshold. The presence of zero-mode quantities above the thresholds may be an indication that there is a grounded fault. Therefore, if there are zero-mode quantities above the thresholds ("high" zero mode quantities), grounded faults may be investigated. On the other hand, if there are no zero-mode quantities above the thresholds ("low" zero mode quantities), phase-to-phase faults may be further investigated.

Referring back to Figure 4, in another embodiment, the phase selection may be based on differential currents. The method 4000 may be equivalent, except in the following:

In step 4010, the method may comprise obtaining current (and voltage) measurements from two measurement points (e.g. L and R in Figures 1 and 2).

In step 4030, the method may, instead of determining transient energies, comprise determining differential currents $I_{diffA}$, $I_{diffB}$, $I_{diffC}$, and/or $I_{diffAB}$, $I_{diffBC}$, $I_{diffCA}$, for each of the phase-to-ground loops and/or each of the phase-to-phase loops. A differential current is the difference between the current measurements for a phase at the two different measurement positions in a given protected transmission line, such as the local point L and the remote point R of the power line 102, 202 in Figures 1 and 2. For example, the differential current for the phase-to-ground loop A-G, at time t, may be calculated as:

$$I_{diffA}(t) = I_{L,A}(t) + I_{R,A}(t).$$

Where the $I_{L,A}(t)$ is the phase A current measured at the local measurement point L, at the local source $S_L$, and $I_{R,A}(t)$ is the phase A current measured at the remote measurement point R, at the remote source $S_R$. Often, the local source $S_L$ and the remote source $S_R$ provide like currents, but in opposite directions.

The method may further comprise determining, incremental differential currents $\Delta_{IdiffA}$, $\Delta I_{diffB}$, $\Delta I_{diffC}$, and/or $\Delta I_{diffAB}$, $\Delta I_{diffBC}$, $\Delta I_{diffCA}$, for each of the phase-to-ground loops and/or phase-to-phase loops, based on the determined differential currents.

The incremental differential currents in a phase-to-ground loop (e.g., A-G) and a phase-to-phase loop (e.g., A-B) may be calculated using the following equations for a time instance t, where time point (t-T) is the time point in a previous fundamental frequency period (T):

$$\Delta I_{diffA}(t) = I_{diffA}(t) - I_{diffA}(t - T)$$

$$\Delta I_{diffAB}(t) = I_{diffAB}(t) - I_{diffAB}(t - T)$$

At step 4040, the method may instead of determining transient energy ratios, comprise determining incremental differential current ratios:

$$R_{Ai} = \frac{\Delta I_{diffA}}{\min(\Delta I_{diffA}, \Delta I_{diffB}, \Delta I_{diffC})}$$

$$R_{Bi} = \frac{\Delta I_{diffB}}{\min(\Delta I_{diffA}, \Delta I_{diffB}, \Delta I_{diffC})} \qquad (4)$$

$$R_{Ci} = \frac{\Delta I_{diffC}}{\min(\Delta I_{diffA}, \Delta I_{diffB}, \Delta I_{diffC})}$$

$$R_{ABi} = \frac{\Delta I_{diffAB}}{\min(\Delta I_{diffAB}, \Delta I_{diffBC}, \Delta I_{diffCA})}$$

$$R_{BCi} = \frac{\Delta I_{diffBC}}{\min(\Delta I_{diffAB}, \Delta I_{diffBC}, \Delta I_{diffCA})} \qquad (5)$$

$$R_{CAi} = \frac{\Delta I_{diffCA}}{\min(\Delta I_{diffAB}, \Delta I_{diffBC}, \Delta I_{diffCA})}$$

At step 4050, the method may instead of comparing the transient energy ratios with corresponding threshold comprise comparing the incremental differential current ratios with corresponding thresholds.

At step 4060, the method may comprise determining a type of fault based on the comparison of the incremental differential current ratios with the corresponding thresholds.

A three-phase fault may be determined based on incremental differential current ratios if:

    1. The incremental zero-mode voltage is below a second incremental zero threshold:

$$\Delta V_0 < \Delta V_{0,set1}$$

    2. All the phase-to ground loop incremental differential current ratios are below a fourth threshold:

$$R_{Ai}, R_{Bi}, R_{Ci} < S_4$$

    3. All loops A-G, B-G, C-G, A-B, B-C, C-A, are fault candidate loops.

A single-phase-to-ground fault for a given phase (using A as an example) may be determined based on incremental differential current ratios if:

    1. The phase-to-ground loop incremental differential current ratio involving the given phase $R_{Ai}$ is larger than the other phase-to-ground loop ratios $R_{Bi}$, $R_{Ci}$:

$$R_{Ai} > R_{Bi}, R_{Ci}$$

    2. The phase-to-phase loop incremental differential current ratios involving the given phase $R_{ABi}$, $R_{CAi}$ are larger than the other phase-to-phase loop incremental differential current ratio $R_{BCi}$:

$$R_{ABi}, R_{CAi} > R_{BCi}$$

    3. The loops involving the given phase (A-G, A-B, C-A) are fault candidate loops.

A two-phase to ground fault for two given phases (using B-C as an example) may be determined based on incremental differential current ratios if:

    1. An incremental zero-mode voltage $\Delta V_0$, obtained from the voltage and current measurements, is large enough, i.e. above a third incremental zero-mode voltage threshold:

$$\Delta V_0 > \Delta V_{0,set3}$$

2. The phase-to-ground loop incremental differential current ratios involving the given phases $R_{Bi}$, $R_{Ci}$ are larger than the other phase-to-ground loop ratio $R_{Ai}$:

$$R_{Bi}, R_{Ci} > R_{Ai}$$

3. All three phase-to-phase loop incremental differential current ratios $R_{ABi}$, $R_{BCi}$, $R_{CAi}$ are small enough, or below a fifth threshold $S_5$:

$$R_{ABi}, R_{BCi}, R_{CAi} < S_5$$

4. The phase-to-ground loops involving the given phases (B-G, C-G) and the phase-to-phase loop involving the given phase (B-C) are fault candidate loops.

A two-phase fault for two given phases (using B-C as an example) may be determined based on incremental differential current ratios if:

1. The phase-to-ground loop incremental differential current ratios involving the given phases $R_B$, $R_C$ are larger than the other phase-to-ground loop ratio $R_A$:

$$R_{Bi}, R_{Ci} > R_{Ai}$$

2. All three phase-to-phase loop incremental differential current ratios $R_{AB}$, $R_{BC}$, $R_{CA}$ are small enough, or below a sixth threshold $S_6$:

$$R_{ABi}, R_{BCi}, R_{CAi} < S_6$$

3. The phase-to-ground loops involving the given phases (B-G, C-G) and the phase-to-phase loop involving the given phase (B-C) are fault candidate loops.

It is noted that, while the method in the above description is based on calculation of current, voltage and energy in the time domain, the method may also be implemented in the phasor domain.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

**Claims**

1.  A method (4000) for determining a type of fault in a power line, the method comprising:

    obtaining (4010) voltage and current measurements at a measurement point of the power line;
    determining (4030) transient energies over a first time period for a number of phase-to-ground loops and phase-to-phase loops of the power line, based on the obtained voltage and current measurements;
    determining (4040) transient energy ratios for the phase-to-ground loops and phase-to-phase loops;
    comparing (4050) the transient energy ratios with thresholds corresponding to the phase-to-ground loops or phase-to-phase loops; and
    determining (4060) a type of fault based on the comparison.

2. The method of claim 1, wherein determining the transient energy ratios comprises:

dividing a phase-to-ground loop transient energy by a lowest one of the determined phase-to-ground loop transient energies; and
dividing a phase-to-phase loop transient energy by a lowest one of the determined phase-to-phase loop transient energies.

3. The method of claim 2, wherein:

if the absolute value of said lowest one of the phase-to-ground loop transient energies is below a first predetermined minimal value, each phase-to-ground-loop transient energy ratio is replaced by a first replacement value; and
if the absolute value of said lowest one of the phase-to-phase loop transient energies is below a second predetermined minimal value, each phase-to-ground-loop transient energy ratio is replaced by a second replacement value.

4. The method of any of the preceding claims, further comprising

obtaining further voltage and current measurements at the measurement point during a second time period;
determining further transient energies over the second time period for the number of phase-to-ground loops and phase-to-phase loops of the power line, based on the obtained further voltage and current measurements;
determining further transient energy ratios for the phase-to-ground loops and the phase-to-phase loops;
comparing the further transient energy ratios with the thresholds corresponding to the phase-to-ground loops or phase-to-phase loops; and
wherein the determining a type of fault is based on the comparison of the transient energy ratios and the comparison of the further transient energy ratios.

5. The method of any of the preceding claims, wherein the types of faults to be determined include phase-to-ground faults and phase-to-phase faults.

6. The method of any of the preceding claims, further comprising obtaining at least one fault candidate loop among the number of phase-to-ground loops and phase-to-phase loops; wherein
the determining a type of fault is further based on the at least one obtained fault candidate loop.

7. The method of claim 6, wherein a three-phase fault is determined if:

a zero-mode voltage, obtained from the voltage and current measurements, is below a first zero-mode voltage threshold;
a zero-mode current, obtained from the voltage and current measurements, is below a first zero-mode current threshold;
all the determined phase-to-ground loop transient energy ratios are below a first threshold level; and
the at least one fault candidate loop comprises all three phase-to-ground loops and all three phase-to-phase loops.

8. The method of any of claims 6 or 7, wherein a single-phase-to-ground fault for a given phase is determined if:

the phase-to-ground loop transient energy ratio for the given phase is higher than the other phase-to-ground loop transient energy ratios;
the phase-to-phase loop transient energy ratios involving the given phase are higher than the phase-to-phase loop transient energy ratios not involving the given phase; and
the phase-to-ground loop for the given phase is a fault candidate loop.

9. The method of any of claims 6-8, wherein a two-phase-to-ground fault for two given phases is determined if:

an incremental zero mode voltage, obtained from the voltage and current measurements, is above a first incremental zero mode voltage threshold;
the phase-to-ground loop transient energy ratios for the two given phases are higher than the other phase-to-ground loop transient energy ratio;

all the phase-to-phase loop transient energy ratios are lower than a second threshold; and
the phase-to-ground loops involving the given phases and the phase-to-phase loop involving the given phases are fault candidate loops.

10. The method of any of claims 6-9, wherein a two-phase fault is determined for two given phases if:

the phase-to-ground loop transient energy ratios involving the given phases are higher than the other phase-to-ground loop transient energy ratio;
all the phase-to-phase-loop transient energy ratios are lower than a third threshold; and
the phase-to-ground loops involving the given phases and the phase-to-phase loop involving the given phases are fault candidate loops.

11. A method for determining a type of fault in a power line, the method comprising:

obtaining (4010) current measurements at a first measurement point of the power line and a second measurement point of the power line;
determining (4030) incremental differential currents over a first time period for a number of phase-to-ground loops and phase-to-phase loops of the power line, based on differential currents calculated from the obtained current measurements;
determining (4040) incremental differential current ratios for the phase-to-ground loops and phase-to-phase loops;
determining (4060) that the type of fault is a single-phase-to-ground fault for a given phase if the phase-to-ground loop incremental differential current ratio for the given phase is larger than the other phase-to-ground loop ratios and if the phase-to-phase loop incremental differential current ratios involving the given phase are larger than the other phase-to-phase loop incremental differential current ratio.

12. The method of claim 11, further comprising:
determining that the type of fault is a two-phase to ground fault for two given phases if an incremental voltage is above an incremental zero threshold, if the phase-to-ground loop incremental differential current ratios involving the two given phases are larger than the other phase-to-ground loop ratio and if all three phase-to-phase loop incremental differential current ratios are below a threshold.

13. The method of claim 12, further comprising:
determining that the type of fault is a three-phase fault if the incremental zero-mode voltage is below another incremental zero threshold and if all the phase-to-ground loop incremental differential current ratios are below another threshold.

14. A device (326) for determining a type of fault in a power line, the device being configured to:

obtain voltage and current measurements from a measurement point of the power line;
determine transient energies over a first time period for a number of phase-to-ground loops and phase-to-phase loops of the power line, based on the obtained voltage and current measurements;
determine transient energy ratios for the phase-to-ground loops and phase-to-phase loops;
compare the transient energy ratios with thresholds corresponding to the phase-to-ground loops or phase-to-phase loops; and
determine a type of fault based on the comparison.

15. A computer readable medium comprising instructions that, when executed by a processor, will bring the processor to:

obtain voltage and current measurements at a measurement point of the power line;
determine transient energies over a first time period for a number of phase-to-ground loops and phase-to-phase loops of the power line, based on the obtained voltage and current measurements;
determine transient energy ratios for the phase-to-ground loops and phase-to-phase loops;
compare the transient energy ratios with thresholds corresponding to the phase-to-ground loops or phase-to-phase loops; and
determine a type of fault based on the comparison.

**Patentansprüche**

1. Verfahren (4000) zum Bestimmen eines Fehlertyps in einer Stromleitung, wobei das Verfahren Folgendes umfasst:

   Erhalten (4010) von Spannungs- und Strommessungen an einem Messpunkt der Stromleitung;
   Bestimmen (4030) von transienten Energien über einen ersten Zeitraum für eine Anzahl von Phase-zu-Masse-Schleifen und Phase-zu-Phase-Schleifen der Stromleitung basierend auf den erhaltenen Spannungs- und Strommessungen;
   Bestimmen (4040) von transienten Energieverhältnissen für die Phase-zu-Masse-Schleifen und Phase-zu-Phase-Schleifen;
   Vergleichen (4050) der transienten Energieverhältnisse mit Schwellenwerten, die den Phasen-zu-Masse-Schleifen oder Phasen-zu-Phase-Schleifen entsprechen; und
   Bestimmen (4060) eines Fehlertyps basierend auf dem Vergleich.

2. Verfahren nach Anspruch 1, wobei das Bestimmen der transienten Energieverhältnisse Folgendes umfasst:

   Dividieren einer transienten Energie für eine Phase-zu-Masse-Schleife durch eine niedrigste der bestimmten transienten Energien für die Phase-zu-Masse-Schleife; und
   Dividieren einer transienten Energie für die Phase-zu-Phase-Schleife durch eine niedrigste der bestimmten transienten Energien für die Phase-zu-Phase-Schleife.

3. Verfahren nach Anspruch 2, wobei:

   falls der Absolutwert der niedrigsten der transienten Energien für die Phase-zu-Masse-Schleife unter einem ersten vorbestimmten Minimalwert liegt, jedes transiente Energieverhältnis für die Phase-zu-Masse-Schleife durch einen ersten Ersatzwert ersetzt wird; und
   falls der Absolutwert der niedrigsten der transienten Energien für die Phase-zu-Phase-Schleife unter einem zweiten vorbestimmten Minimalwert liegt, jedes transiente Energieverhältnis für die Phase-zu-Masse-Schleife durch einen zweiten Ersatzwert ersetzt wird.

4. Verfahren nach einem der vorhergehenden Ansprüche, das ferner Folgendes umfasst:

   Erhalten weiterer Spannungs- und Strommessungen an dem Messpunkt während eines zweiten Zeitraums;
   Bestimmen weiterer transienter Energien über den zweiten Zeitraum für die Anzahl von Phase-zu-Masse-Schleifen und Phase-zu-Phase-Schleifen der Stromleitung basierend auf den erhaltenen weiteren Spannungs- und Strommessungen;
   Bestimmen weiterer transienter Energieverhältnisse für die Phase-zu-Masse-Schleifen und die Phase-zu-Phase-Schleifen;
   Vergleichen der weiteren transienten Energieverhältnisse mit den Schwellenwerten, die den Phase-zu-Masse-Schleifen oder Phase-zu-Phase-Schleifen entsprechen; und wobei das Bestimmen eines Fehlertyps auf dem Vergleich der transienten Energieverhältnisse und dem Vergleich der weiteren transienten Energieverhältnisse basiert.

5. Verfahren nach einem der vorhergehenden Ansprüche, wobei die zu bestimmenden Fehlertypen Phase-zu-Masse-Fehler und Phase-zu-Phase-Fehler beinhalten.

6. Verfahren nach einem der vorhergehenden Ansprüche, das ferner Folgendes umfasst:

   Erhalten mindestens einer Fehlerkandidatenschleife unter der Anzahl von Phase-zu-Masse-Schleifen und Phase-zu-Phase-Schleifen; wobei
   das Bestimmen eines Fehlertyps ferner auf der mindestens einen erhaltenen Fehlerkandidatenschleife basiert.

7. Verfahren nach Anspruch 6, wobei ein Dreiphasenfehler bestimmt wird, falls:

   eine Nullmodusspannung, die aus den Spannungs- und Strommessungen erhalten wird, unterhalb eines ersten Nullmodusspannungsschwellenwertes liegt;
   ein Nullmodusstrom, der aus den Spannungs- und Strommessungen erhalten wird, unterhalb eines ersten Nullmodusstromschwellenwertes liegt;

alle bestimmten transienten Energieverhältnisse für die Phase-zu-Masse-Schleife unter einem ersten Schwellenwertpegel liegen; und

die mindestens eine Fehlerkandidatenschleife alle Dreiphasen-zu-Masse-Schleifen und alle Dreiphasen-zu-Phase-Schleifen umfasst.

8. Verfahren nach einem der Ansprüche 6 oder 7, wobei ein Einphasen-zu-Masse-Fehler für eine gegebene Phase bestimmt wird, falls:

das transiente Energieverhältnis für die Phase-zu-Masse-Schleife für die gegebene Phase höher ist als die anderen transienten Energieverhältnisse für die Phase-zu-Masse-Schleife;
die transienten Energieverhältnisse für die Phase-zu-Phase-Schleife, die die gegebene Phase involvieren, höher sind als die transienten Energieverhältnisse für die Phase-zu-Phase-Schleife, die die gegebene Phase nicht involvieren; und
die Phase-zu-Masse-Schleife für die gegebene Phase eine Fehlerkandidatenschleife ist.

9. Verfahren nach einem der Ansprüche 6-8, wobei ein Zweiphasen-zu-Masse-Fehler für zwei gegebene Phasen bestimmt wird, falls:

eine inkrementelle Nullmodusspannung, die aus den Spannungs- und Strommessungen erhalten wird, über einem ersten inkrementellen Nullmodusspannungsschwellenwert liegt;
die transienten Energieverhältnisse für die Phase-zu-Masse-Schleife für die zwei gegebenen Phasen höher sind als das andere transiente Energieverhältnis für die Phase-zu-Masse-Schleife;
alle transienten Energieverhältnisse für die Phase-zu-Phase-Schleifen niedriger sind als ein zweiter Schwellenwert; und
die Phase-zu-Masse-Schleifen, die die gegebenen Phasen involvieren, und die Phase-zu-Phase-Schleife, die die gegebenen Phasen involvieren, Fehlerkandidatenschleifen sind.

10. Verfahren nach einem der Ansprüche 6-9, wobei ein Zweiphasenfehler für zwei gegebene Phasen bestimmt wird, falls:

die transienten Energieverhältnisse für die Phase-zu-Masse-Schleifen, die die gegebenen Phasen involvieren, höher sind als das andere transiente Energieverhältnis für die Phase-zu-Masse-Schleifen;
alle transienten Energieverhältnisse für die Phase-zu-Phase-Schleifen niedriger als ein dritter Schwellenwert sind; und
die Phase-zu-Masse-Schleifen, die die gegebenen Phasen involvieren, und die Phase-zu-Phase-Schleife, die die gegebenen Phasen involvieren, Fehlerkandidatenschleifen sind.

11. Verfahren zum Bestimmen eines Fehlertyps in einer Stromleitung, wobei das Verfahren Folgendes umfasst:

Erhalten (4010) von Strommessungen an einem ersten Messpunkt der Stromleitung und einem zweiten Messpunkt der Stromleitung;
Bestimmen (4030) inkrementeller Differenzströme über einen ersten Zeitraum für eine Anzahl von Phase-zu-Masse-Schleifen und Phase-zu-Phase-Schleifen der Stromleitung basierend auf Differenzströmen, die aus den erhaltenen Strommessungen berechnet werden;
Bestimmen (4040) inkrementeller Differenzstromverhältnisse für die Phase-zu-Masse-Schleifen und Phase-zu-Phase-Schleifen;
Bestimmen (4060), dass der Fehlertyp ein Einphasen-zu-Masse-Fehler für eine gegebene Phase ist, falls das inkrementelle Differenzstromverhältnis der Phase-zu-Masse-Schleife für die gegebene Phase größer ist als die anderen Verhältnisse der Phase-zu-Masse-Schleife und falls die inkrementellen Differenzstromverhältnisse der Phase-zu-Phase-Schleife, die die gegebene Phase involvieren, größer als das andere inkrementelle Differenzstromverhältnis der Phase-zu-Phase-Schleife sind.

12. Verfahren nach Anspruch 11, das ferner Folgendes umfasst:
Bestimmen, dass der Fehlertyp ein Zweiphasen-zu-Masse-Fehler für zwei gegebene Phasen ist, falls eine inkrementelle Spannung über einem inkrementellen Nullschwellenwert liegt, falls die inkrementellen Differenzstromverhältnisse der Phase-zu-Masse-Schleife, die die zwei gegebenen Phasen involvieren, größer als das andere Verhältnis der Phase-zu-Masse-Schleife sind und falls alle inkrementellen Differenzstromverhältnisse der Dreiphasen-zu-Phase-Schleife unter einem Schwellenwert liegen.

**13.** Verfahren nach Anspruch 12, das ferner Folgendes umfasst:

Bestimmen, dass der Fehlertyp ein dreiphasiger Fehler ist, falls die inkrementelle Nullmodusspannung unter einem anderen inkrementellen Nullschwellenwert liegt und falls alle inkrementellen Differenzstromverhältnisse der Phase-zu-Masse-Schleife unter einem anderen Schwellenwert liegen.

**14.** Vorrichtung (326) zum Bestimmen eines Fehlertyps in einer Stromleitung, wobei die Vorrichtung konfiguriert ist, um:

Spannungs- und Strommessungen von einem Messpunkt der Stromleitung zu erhalten;
transiente Energien über einen ersten Zeitraum für eine Anzahl von Phase-zu-Masse-Schleifen und Phase-zu-Phase-Schleifen der Stromleitung basierend auf den erhaltenen Spannungs- und Strommessungen zu bestimmen;
transiente Energieverhältnisse für die Phase-zu-Masse-Schleifen und Phase-zu-Phase-Schleifen zu bestimmen;
die transienten Energieverhältnisse mit Schwellenwerten zu vergleichen, die den Phase-zu-Masse-Schleifen oder Phase-zu-Phase-Schleifen entsprechen; und
einen Fehlertyp basierend auf dem Vergleich zu bestimmen.

**15.** Computerlesbares Medium, das Anweisungen umfasst, die, wenn sie durch einen Prozessor ausgeführt werden, den Prozessor zu Folgendem bringen:

Spannungs- und Strommessungen an einem Messpunkt der Stromleitung zu erhalten;
transiente Energien über einen ersten Zeitraum für eine Anzahl von Phase-zu-Masse-Schleifen und Phase-zu-Phase-Schleifen der Stromleitung basierend auf den erhaltenen Spannungs- und Strommessungen zu bestimmen;
transiente Energieverhältnisse für die Phase-zu-Masse-Schleifen und Phase-zu-Phase-Schleifen zu bestimmen;
die transienten Energieverhältnisse mit Schwellenwerten zu vergleichen, die den Phase-zu-Masse-Schleifen oder Phase-zu-Phase-Schleifen entsprechen; und
einen Fehlertyp basierend auf dem Vergleich zu bestimmen.

## Revendications

**1.** Procédé (4000) pour déterminer un type de défaut sur une ligne d'alimentation, le procédé comprenant :

l'obtention (4010) de mesures de tension et de courant en un point de mesure de la ligne d'alimentation ;
la détermination (4030) d'énergies transitoires sur une première période de temps pour un certain nombre de boucles phase-terre et de boucles phase-phase de la ligne d'alimentation, sur la base des mesures de tension et de courant obtenues ;
la détermination (4040) de rapports d'énergies transitoires pour les boucles phase-terre et les boucles phase-phase ;
la comparaison (4050) des rapports d'énergies transitoires à des seuils correspondant aux boucles phase-terre ou aux boucles phase-phase ; et
la détermination (4060) d'un type de défaut sur la base de la comparaison.

**2.** Procédé selon la revendication 1, dans lequel la détermination des rapports d'énergies transitoires comprend :

la division d'une énergie transitoire de boucle phase-terre par la plus faible des énergies transitoires de boucle phase-terre déterminées ; et
la division d'une énergie transitoire de boucle phase-phase par la plus faible des énergies transitoires de boucle phase-phase déterminées.

**3.** Procédé selon la revendication 2, dans lequel :

si la valeur absolue de ladite plus faible des énergies transitoires de boucle phase-terre est inférieure à une première valeur minimale prédéterminée, chaque rapport d'énergies transitoires de boucle phase-terre est remplacé par une première valeur de remplacement ; et
si la valeur absolue de ladite plus faible des énergies transitoires de boucle phase-phase est inférieure à une deuxième valeur minimale prédéterminée, chaque rapport d'énergies transitoires de boucle phase-terre est remplacé par une deuxième valeur de remplacement.

4.  Procédé selon l'une quelconque des revendications précédentes, comprenant en outre

l'obtention de mesures de tension et de courant supplémentaires au point de mesure pendant une deuxième période de temps ;
la détermination d'énergies transitoires supplémentaires sur la deuxième période de temps pour le nombre de boucles phase-terre et de boucles phase-phase de la ligne d'alimentation, sur la base des mesures de tension et de courant supplémentaires obtenues ;
la détermination de rapports d'énergies transitoires supplémentaires pour les boucles phase-terre et les boucles phase-phase ;
la comparaison des rapports d'énergies transitoires supplémentaires aux seuils correspondant aux boucles phase-terre ou aux boucles phase-phase ; et
la détermination d'un type de défaut étant basée sur la comparaison des rapports d'énergies transitoires et la comparaison des rapports d'énergies transitoires supplémentaires.

5.  Procédé selon l'une quelconque des revendications précédentes, dans lequel les types de défauts à déterminer incluent des défauts phase-terre et des défauts phase-phase.

6.  Procédé selon l'une quelconque des revendications précédentes, comprenant en outre

l'obtention d'au moins une boucle candidate à un défaut parmi le nombre de boucles phase-terre et de boucles phase-phase ;
la détermination d'un type de défaut étant en outre basée sur l'au moins une boucle candidate à un défaut obtenue.

7.  Procédé selon la revendication 6, dans lequel il est déterminé un défaut sur trois phases si :

une tension en mode zéro, obtenue à partir des mesures de tension et de courant, est inférieure à un premier seuil de tension en mode zéro ;
un courant en mode zéro, obtenu à partir des mesures de tension et de courant, est inférieur à un premier seuil de courant en mode zéro ;
tous les rapports d'énergies transitoires de boucle phase-terre déterminés sont inférieurs à un premier niveau seuil ; et
l'au moins une boucle candidate à un défaut comprend l'ensemble des trois boucles phase-terre et l'ensemble des trois boucles phase-phase.

8.  Procédé selon l'une quelconque des revendications 6 ou 7, dans lequel il est déterminé un défaut sur une seule phase par rapport à la terre pour une phase donnée si :

le rapport d'énergies transitoires de boucle phase-terre pour la phase donnée est supérieur aux autres rapports d'énergies transitoires de boucle phase-terre ;
les rapports d'énergies transitoires de boucle phase-phase impliquant la phase donnée sont supérieurs aux rapports d'énergies transitoires de boucle phase-phase n'impliquant pas la phase donnée ; et
la boucle phase-terre pour la phase donnée est une boucle candidate à un défaut.

9.  Procédé selon l'une quelconque des revendications 6 à 8, dans lequel il est déterminé un défaut sur deux phases par rapport à la terre pour deux phases données si :

une tension incrémentale en mode zéro, obtenue à partir des mesures de tension et de courant, est supérieure à un premier seuil de tension incrémentale en mode zéro ;
les rapports d'énergies transitoires de boucle phase-terre pour les deux phases données sont supérieurs à l'autre rapport d'énergies transitoires de boucle phase-terre ;
tous les rapports d'énergies transitoires de boucle phase-phase sont inférieurs à un deuxième seuil ; et
les boucles phase-terre impliquant les phases données et les boucles phase-phase impliquant les phases données sont des boucles candidates à un défaut.

**10.** Procédé selon l'une quelconque des revendications 6 à 9, dans lequel il est déterminé un défaut sur deux phases pour deux phases données si :

les rapports d'énergies transitoires de boucle phase-terre impliquant les phases données sont supérieurs à l'autre rapport d'énergies transitoires de boucle phase-terre ;
tous les rapports d'énergies transitoires de boucle phase-phase sont inférieurs à un troisième seuil ; et
les boucles phase-terre impliquant les phases données et les boucles phase-phase impliquant les phases données sont des boucles candidates à un défaut.

**11.** Procédé pour déterminer un type de défaut sur une ligne d'alimentation, le procédé comprenant :

l'obtention (4010) de mesures de courant en un premier point de mesure de la ligne d'alimentation et un deuxième point de mesure de la ligne d'alimentation ;
la détermination (4030) de courants différentiels incrémentaux sur une première période de temps pour un certain nombre de boucles phase-terre et de boucles phase-phase de la ligne d'alimentation, sur la base de courants différentiels calculés à partir des mesures de courant obtenues ;
la détermination (4040) de rapports de courants différentiels incrémentaux pour les boucles phase-terre et les boucles phase-phase ;
la détermination (4060) du fait que le type de défaut est un défaut sur une seule phase par rapport à la terre pour une phase donnée si le rapport de courants différentiels incrémentaux de boucle phase-terre pour la phase donnée est supérieur aux autres rapports de boucles phase-terre et si les rapports de courants différentiels incrémentaux de boucle phase-phase impliquant la phase donnée sont supérieurs à l'autre rapport de courants différentiels incrémentaux de boucle phase-phase.

**12.** Procédé selon la revendication 11, comprenant en outre :
la détermination du fait que le type de défaut est un défaut sur deux phases par rapport à la terre pour deux phases données si une tension incrémentale est supérieure à un seuil de zéro incrémental, si les rapports de courants différentiels incrémentaux de boucle phase-terre impliquant les deux phases données sont supérieurs à l'autre rapport de boucle phase-terre et si les trois rapports de courants différentiels incrémentaux de boucles phase-phase sont inférieurs à un seuil.

**13.** Procédé selon la revendication 12, comprenant en outre :
la détermination du fait que le type de défaut est un défaut sur trois phases si la tension incrémentale en mode zéro est inférieure à un autre seuil de zéro incrémental et si tous les rapports de courants différentiels incrémentaux de boucle phase-terre sont inférieurs à un autre seuil.

**14.** Dispositif (326) pour déterminer un type de défaut sur une ligne d'alimentation, le dispositif étant configuré pour :

obtenir des mesures de tension et de courant à partir d'un point de mesure de la ligne d'alimentation ;
déterminer des énergies transitoires sur une première période de temps pour un certain nombre de boucles phase-terre et de boucles phase-phase de la ligne d'alimentation, sur la base des mesures de tension et de courant obtenues ;
déterminer des rapports d'énergies transitoires pour les boucles phase-terre et les boucles phase-phase ;
comparer les rapports d'énergies transitoires à des seuils correspondant aux boucles phase-terre ou aux boucles phase-phase ; et
déterminer un type de défaut sur la base de la comparaison.

**15.** Un support lisible par ordinateur, comprenant des instructions qui, lorsqu'elles sont exécutées par un processeur, amènent le processeur à :

obtenir des mesures de tension et de courant en un point de mesure de la ligne d'alimentation ;
déterminer des énergies transitoires sur une première période de temps pour un certain nombre de boucles phase-terre et de boucles phase-phase de la ligne d'alimentation, sur la base des mesures de tension et de courant obtenues ;
déterminer des rapports d'énergies transitoires pour les boucles phase-terre et les boucles phase-phase ;
comparer les rapports d'énergies transitoires à des seuils correspondant aux boucles phase-terre ou aux boucles phase-phase ; et
déterminer un type de défaut sur la base de la comparaison.

*Fig. 1*

*Fig. 2*

*Fig. 3*

*4000*

4010

4020

4030

4040

4050

4060 — N

Y

4070

Fig. 4

*5060*

5062 — N

Y

5064

5066 — N → 5010

Y

5070

Fig. 5

*6000*

6010

6022

6024

6026 — N

Y

6030

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LUO et al.** Fast phase selection method based on transient current for UHV transmission lines. *JOURNAL OF ENGINEERING, INSTITUTION OF ENGINEERING AND TECHNOLOGY*, 01 October 2018, vol. 2018 (15), 938-943